Europäisches Patentamt

(19) European Patent Office

Office européen des brevets

(11) Publication number: **0 034 358**
**B1**

(12) **EUROPEAN PATENT SPECIFICATION**

(45) Date of publication of patent specification: **26.03.86**

(21) Application number: **81101059.4**

(22) Date of filing: **14.02.81**

(51) Int. Cl.⁴: **B 64 D 25/14,** A 62 B 1/20

(54) **Escape slide and life raft.**

(30) Priority: **19.02.80 US 122334**

(43) Date of publication of application:
**26.08.81 Bulletin 81/34**

(45) Publication of the grant of the patent:
**26.03.86 Bulletin 86/13**

(84) Designated Contracting States:
**DE FR GB**

(56) References cited:
**GB-A-1 201 914**
**GB-A-1 201 916**
**GB-A-1 206 936**
**US-A-3 461 995**
**US-A-3 679 025**
**US-A-3 833 088**

(73) Proprietor: **The B.F. GOODRICH Company**
**Dept. 0015 WHB-6 500 South Main Street**
**Akron, Ohio 44318 (US)**

(72) Inventor: **Fisher, John Melvin**
**622 Sackett Avenue**
**Cuyahoga Falls Ohio 44221 (US)**

(74) Representative: **von Kreisler, Alek, Dipl.-Chem.**
**et al**
**Deichmannhaus am Hauptbahnhof**
**D-5000 Köln 1 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Description

The invention relates to an escape slide and life raft assembly adapted to be inflated and extend from an elevated position to a lower surface comprising a slide portion having at least one longitudinally extending inflatable side tube at one side of said slide portion, an outrigger portion positioned adjacent said side tube, said outrigger portion having at least one support tube extending in the longitudinal direction and being connected to said side tube by spaced-apart transverse support tubes, and a flexible sheet material passenger supporting member extending between said side tube, said transverse support tubes and said support tube, so that during operation of said assembly as a life raft, said outrigger portion will provide space on said supporting member for additional passengers, a reefing means being fastened to said assembly for retaining said outrigger portion against said slide portion and including release means for releasing said reefing means.

Such an escape slide and the life raft assembly is known from GB—A—1 201 914.

With larger capacity aircraft and fewer doors located above the water during a ditching situation, the slide/life raft systems used heretofore have not had the seating space and buoyancy necessary to float the number of persons who are expected to leave the aircraft at one door. Although one solution to this problem is to make the slide larger, this has its limitations in view of the requirement that the slide needs to be deployable in a matter of seconds. Also the vulnerability of the assembly to wind forces is greater with a larger assembly. It is also necessary to limit the weight and storage space required for the slide while at the same time providing the structural integrity needed during operation.

In GB—A—1 201 914 an inflatable escape slide is described which has an outrigger portion on either side of two parallel inflatable side tubes which are connected to each other by an intermediate slide member. Each outrigger portion comprises a support tube running in parallel to the adjacent side tube and two short end sections which each extend at an angle to the associated side tube. Each outrigger portion can be held in a reefed condition against the corresponding side tube during the initial evacuation of personnel of the air craft by straps connected to the side tubes. If the escape slide is inflated both, the side tubes and the support tubes are fully inflated. By loosening the straps each support tube which has been held on the top of the corresponding side tube move sidewardly to form the outrigger portion.

It is the object of the invention to provide an escape slide of the type mentioned initially which escape slide includes a high pressure when it is used as a slide which needs high stability and rigidity and which includes a lower pressure when it is used as a raft with the outrigger portion in extended condition.

The escape slide and life raft assembly according to the invention is characterized in that said reefing means includes a continuous flap of sheet material extending in the reefed condition around said support tube and urging the length of said support tube against said side tube so that, upon inflation of said assembly with said outrigger portion in the reefed condition, said support tube, over its total length, will be only partially inflated and reinforce said side tube of said slide portion.

The outrigger portion is partially inflated in the reefed condition to provide reinforcement of the side tubes of the slide portion so that the size and weight of the side tubes may be reduced. The outrigger portion is inflatable by the pressure of the gases in the slide portion upon release of the reefing.

The drawings show a preferred embodiment of the invention in detail.

Fig. 1 is a partially schematic view in perspective of an inflatable slide and life raft assembly mounted on an aircraft floating in the water with the slide portion inflated and extended but with the outrigger portion in the reefed condition.

Fig. 2 is a view like Fig. 1 but showing the assembly after the outrigger portions have been fully extended and inflated.

Fig. 3 is a view like Figs. 1 and 2 showing the assembly after being released from the aircraft and the canopy installed.

Fig. 4 is a side elevation of the assembly as shown in Fig. 1 with the aircraft fuselage shown in chain-dotted lines.

Fig. 5 is a schematic cross-sectional view taken on the plane of line 5—5 in Fig. 4.

Fig. 6 is a side elevation of the assembly as shown in Fig. 2 with the slide tilted in a horizontal position.

Fig. 7 is a schematic cross-sectional view taken on the plane of lines 7—7 in Fig. 6.

Fig. 8 is a fragmentary view in perspective of the assembly as shown in Fig. 1 showing the slide portion inflated and the outrigger portion reefed by the reefing flaps which are connected by the release means.

Fig. 9 is an enlarged fragmentary view of the release means connecting the lower and upper reefing flaps and the actuating apparatus for the release means.

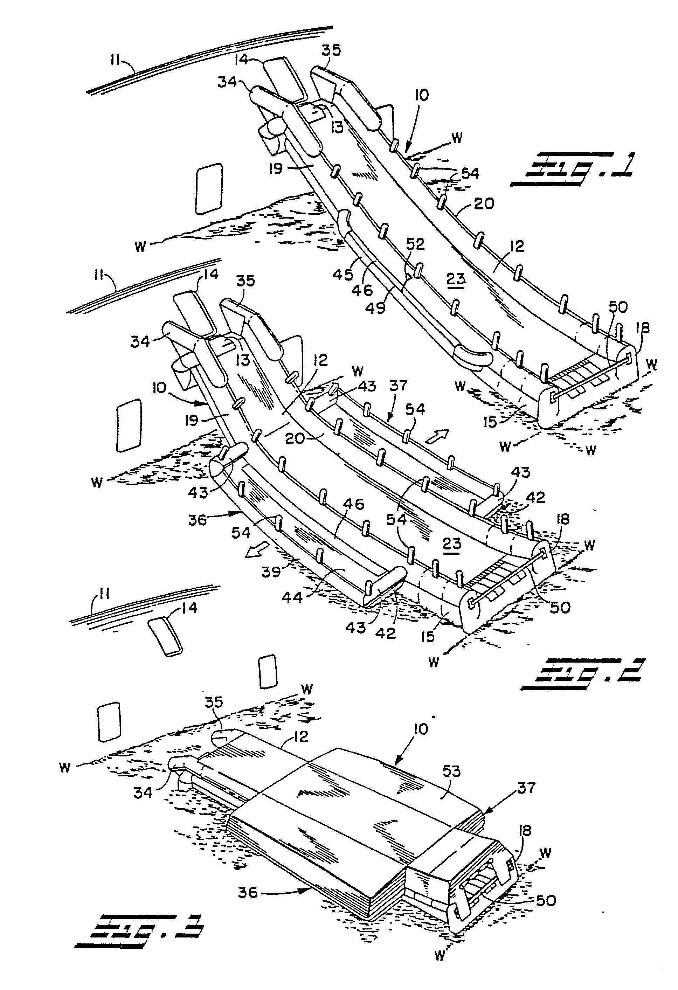

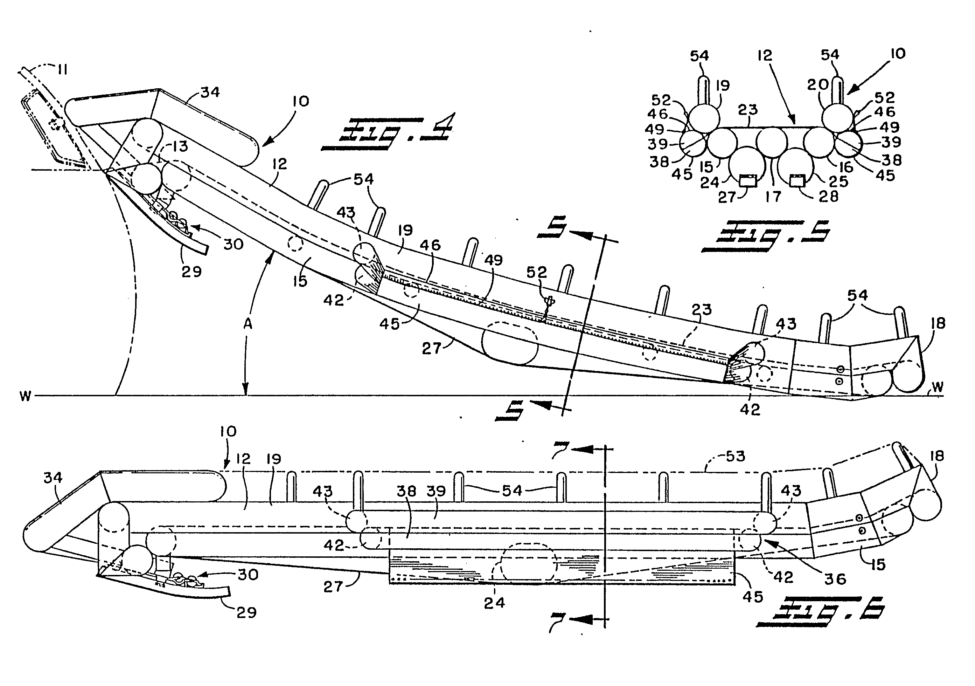

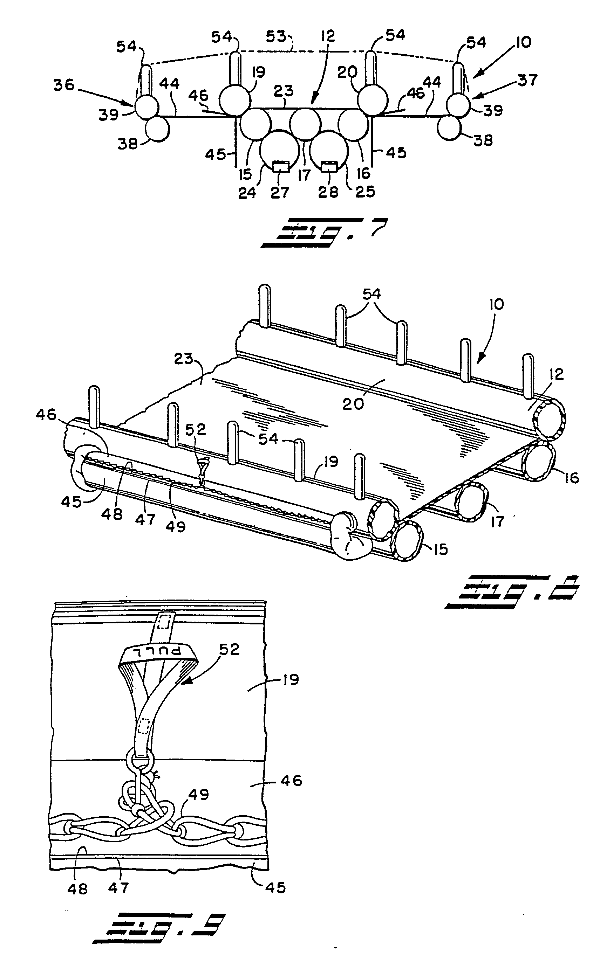

Referring to Figs. 1, 4 and 5, a multitubular inflatable escape slide and life raft assembly 10 is shown in the inflated condition in position for evacuating passengers from an elevated supporting structure such as an aircraft having a fuselage 11 shown schematically in Fig. 1 and in chain-dotted lines in Fig. 4. A slide portion 12 of the assembly 10 is shown in a position for evacuating passengers from the aircraft with the fuselage 11 partially submerged in water after the aircraft has been ditched. The waterline is indicated by lines W—W in the drawings. As shown in Fig. 4, the slide portion 12 is positioned at an angle A of approximately 30 degrees for evacuating personnel with the fuselage 11 in the ditched position. It is understood that when passengers are evacuated from the aircraft to the ground, the inclination of the slide portion 12 may be at an angle A of from approximately 34 degrees to 48 degrees to the horizontal.

The slide portion 12 in the inflated condition has a generally horizontal platform 13 at the girt end which is fastened to the fuselage 11 at a doorway 14 in the fuselage. As shown in Figs. 4 and 5, the slide portion 12 has a multitubular construction including a left-hand lower side tube 15, a right-hand lower side tube 16, and a central main tube 17, all of which extend longitudinally of slide portion from the platform 13 to a toe end 18 of the slide portion. The side tubes 15 and 16 and the central main tube 17 may be connected by separating tubes (not shown). The slide portion 12 also has a longitudinally extending left-hand upper side rail tube 19 mounted on the top of the left-hand lower side tube 15 and a right-hand upper side rail tube 20 mounted on the right-hand lower side tube 16. A center slide panel 23 is fastened to the lower side tubes 15 and 16 and to the central main tube 17 between the upper side rail tubes 19 and 20 providing a slide surface on which the passengers may slide to the toe end 18 during evacuation of the aircraft.

Truss tubes 24 and 25 may be fastened to the underside of the lower side tubes 15 and 16 and the central main tube 17 at positions approximately one-half the length of the slide portion 12 from the ends of the slide. Elongated longitudinally extending slide reinforcing tension members in the form of straps 27 and 28 engage the lower surface of the truss tubes 24 and 25 and are fastened to the underside of the slide portion at positions near the toe end 18 and platform 13.

An upper deck door 29 becomes part of the slide portion 12 and an inflation system 30 is mounted on the door for inflating the slide portion. The inflation system 30 is of a sufficient size to inflate the slide portion 12 in about two seconds inflation time to a pressure of about three pounds per square inch (0,21 bar).

The slide portion 12 may be constructed of a suitable flexible material such as square-woven nylon fabric impregnated with neoprene to retain air or other inflation medium in the inflatable parts. The straps 27 and 28 and the slide panel 23 may also be of square-woven nylon and adhered to the slide portion 12 by a suitable adhesive. The inflatable tubes 15, 16, 17, 19, 20, 24 and 25 may be of a nylon fabric which is stretchable at the inflation pressure of three pounds per square inch (0,21 bar) for operation of the slide portion 12 but contractible at lower pressures to reduce the volume of the assembly.

Other parts may be incorporated in the slide portion 12 such as rail tubes 34 and 35 which are fastened to the upper side rail tubes 19 and 20, respectively.

As shown in Figs. 2, 6 and 7 of the escape slide and life raft assembly 10, outrigger portions 36 and 37 are positioned at each side of the slide portion 12 adjacent the side tubes 15 and 16 and side rail tubes 19 and 20. Since each of the outrigger portions 36 and 37 are of similar construction, the following description will be directed to outrigger portion 36 with the understanding that the outrigger portion 37 has the same construction. Similar parts for outrigger portion 37 will be designated with the same numerals as the parts for outrigger portion 36.

A lower side support tube 38 and an upper side support tube 39 of the outrigger portion 36 extend longitudinally of the assembly 10 at a spaced position from the lower side tube 15 and upper side rail tube 19 of the slide portion 12. Lower transverse support tubes 42 and upper transverse support tubes 43 of the outrigger portion 36 are attached to the left-hand lower side tube 15 and left-hand upper side rail tube 19, respectively, for communication of the inflating gases from the slide portion 12 to the outrigger portion 36.

A passenger supporting panel member 44 extends between the left-hand lower side tube 15 of the slide portion 12 and the lower side support tube 38 and lower transverse support tubes 42 of the outrigger portion 36 for supporting the passengers. The panel member 44 may be of flexible sheet material such as square-woven nylon impregnated with neoprene®.

A lower reefing flap 45 and an upper reefing flap 46 are attached to the escape slide and life raft assembly 10 and each of the flaps has one edge hingedly attached to the slide portion 12 at a suitable position such as between the left-hand lower side tube 15 and upper side rail tube 19. In the deflated condition of the outrigger portion 36, the reefing flaps 45 and 46 extend around the lower side support tube 38 and upper side support tube 39 of the outrigger portion and edges 47 and 48 of the flaps are releasably connected by suitable fast-release apparatus such as speed lacing 49 which may be instantly released by pulling a release handle 52 attached to the left-hand upper side rail tube 19. As shown in Figs. 5 and 8, the lower side support tube 38 and upper side support tube 39 of the outrigger portion 36 are partially inflated and provide reinforcement of the edges of the slide portion 12 so that the lower side tube 15 and upper side rail tube 19 may have a smaller diameter than would be necessary without the reinforcing support provided by the support tubes of the outrigger portion 36.

Because the escape slide and life raft assembly 10 will be used as a raft very infrequently, the assembly is designed with the outrigger portions 36 and 37 normally reefed in against the sides of the slide portion 12. Accordingly, when the slide portion 12 is inflated and extended in the position shown in Figs. 1, 4 and 5, the amount of gas required is reduced because the outrigger portions 36 and 37 are only inflated to approximately 30 percent of their normal volume. After the passengers have escaped onto the slide portion 12, the slide is in a configuration shown in Fig. 2. The release handles 52 may then be pulled allowing the speed lacing 49 to unravel and the gas in the slide portion 12 to expand the outrigger portions 36 and 37. The pressure-to-volume relationship of the escape slide and life raft assembly 10 is such that an initial pressure of about three pounds per square inch (0,21 bar) in the slide portion 12 will be (0,07 bar) reduced to approximately one pound per square inch or higher. The effect of the stretched nylon® fabric in the inflatable tubes of a slide portion 12 retracting to an unstretched condition under the reduced pressure will also tend to maintain the pressure within the assembly at a higher pressure than that calculated by comparing the change in inflatable volume. This feature permits possible higher raft operating pressures or a lower constraining force in the reefed assembly. After the outrigger portions 36 and 37 are inflated, the passengers may step into them and be seated on the passenger support panel members 44. Backrests are provided by the upper side support tubes 39 and upper side rail tubes 19 and 20 of the outrigger portions 36, 37 and slide portion 12.

When the first passenger or flight attendant slides down the slide portion 12, a passenger retention strap 50 is secured across the toe end 18 of the slide between side rail tubes 19 and 20 to prevent people from sliding off the end of the slide portion. As shown in Fig. 3, the esacape slide and life raft assembly 10 may be detached from the fuselage 11 and a canopy 53 installed over inflatable vertical supports 54, shown in the other figures. The supports 54 are positioned on the upper sides of the upper side rail tubes 19 and 20 of the slide portion 12 and the upper support tubes 39 of the outrigger portions 36 and 37.

**Claims**

1. An escape slide and life raft assembly adapted to be inflated and extend from an elevated position to a lower surface comprising a slide portion (12) having at least one longitudinally extending inflatable side tube (15, 16, 19, 20) at one side of said slide portion, an outrigger portion (36) positioned adjacent said tube, said outrigger portion having at least one support tube (38, 39) extending in the longitudinal direction and being connected to said side tube (19, 20) by spaced-apart transverse support tubes (42, 43), and a flexible sheet material passenger supporting member (44) extending between said side tube (19, 20), said transverse support tubes (42, 43) and said support tube (38, 39), so that during operation of said assembly as a life raft, said outrigger portion (36) will provide space on said supporting member (44) for additional passengers, a reefing means (45, 46) being fastened to said assembly for retaining said outrigger portion (36) against said slide portion (12) and including release means (49) for releasing said reefing means (45, 46), characterized in that said reefing means (45, 46) including a continuous flap of sheet material extending in the reefed condition around said support tube (38, 39) and urging the length of said support tube against said side tube (19, 20) so that, upon inflation of said assembly with said outrigger portion (36) in the reefed condition, said support tube, over its total length, will be only partially inflated and reinforce said side tube (19, 20) of said slide portion.

2. An escape slide and life raft assembly in accordance with claim 1, wherein said assembly is inflated to a first predetermined pressure while said outrigger portion (36) is in the reefed condition and then said assembly is inflated to a second predetermined pressure with the outrigger portion (36) in the extended condition after release of said reefing means (45, 46) by said release means (49) wherein said first predetermined pressure is about 0.21 bar and said second predetermined pressure is about 0.07 bar.

3. An escape slide and life raft assembly in accordance with claim 2 wherein said side tube (19, 20) is of a fabric stretchable at said first predetermined pressure to increase the volume of said assembly during extension of said slide portion (12) and thereby minimize the reduction in pressure in said assembly during the extension of said outrigger portion (36).

4. An escape slide and life raft assembly in accordance with claim 1 wherein said slide portion (12) has a second side tube (19, 20) at an opposite edge from said first mentioned side tube and a second outrigger portion (37) positioned adjacent said second side tube, said second outrigger portion having a second support tube (38, 39) attached to and in communication with said second side tube and a second flexible sheet material passenger supporting member (44) extending between said second side tube and said second support tube so that during operation of said assembly as a life raft, said second outrigger portion (37) will provide space for additional passengers.

5. An escape and life raft assembly in accordance with claim 4 wherein a second reefing means (45, 46) is provided to retain said second support tube (38, 39) in a partially inflated condition against said slide portion (12) and a second release means for releasing said second reefing means independently of the release of said first outrigger portion (36).

**Patentansprüche**

1. Notrutschen— und Rettungsfloßeinrichtung zum Aufblasen und Erstrecken von einer erhöhten Position zu einer tiefer gelegenen Fläche, mit einem Rutschenteil (12), der an einer Seite mindestens ein sich in Längsrichtung erstreckendes aufblasbares Seitenrohr (15, 16, 19, 20) aufweist, einem neben dem Seitenrohr angeordneten Auslegerteil (36), welcher mindestens ein sich in Längsrichtung erstreckendes Stützrohr (38, 39) aufweist und mit dem Seitenrohr (19, 20) über mit gegenseitigem Abstand angeordnete Quer-Stützrohre (42, 43) verbunden ist, und einem aus flexiblem Flächenmaterial bestehenden Passagier-Tragteil (44), welcher sich zwischen den Seitenrohren (19, 20), den Quer-Stützrohren (42, 43) und dem Stützrohr (38, 39) erstreckt, wobei der Auslegerteil (36) auf dem Tragteil (44) Raum für zusätzliche Passagiere bereitstellt, einer an der Einrichtung befestigten Reff-Vorrichtung (45, 46) zum Zurückhalten des Auslegerteils (36) an dem Rutschteil (12), wobei die Reff-Vorrichtung (45, 46) durch eine Auslösevorrichtung (49) freigebbar ist, dadurch gekennzeichnet, daß die Reff-Vorrichtung (45, 46) eine kontinuierliche Lasche aus Flächenmaterial aufweist, die sich Reff-Zustand um das Stützrohr (38, 39) herum erstreckt und die Länge dieses Stützrohres gegen das Seitenrohr (19, 20) drückt, so daß das Stützrohr beim Aufblasen der Einrichtung bei gerefftem Auslegerteil (36) über seine gesamte Länge nur teilweise aufgeblasen wird und das Seitenrohr (18, 19) des Rutschenteils verstärkt.

2. Notrutschen— und Rettungsfloßeinrichtung nach Anspruch 1, bei welcher die Einrichtung auf einen vorbestimmten ersten Druck aufgeblasen wird, während der Auslegerteil (36) im Reffzustand ist, und dann nach dem Freigeben der Reffvorrichtung (45, 46) durch die Auslösevorrichtung (49) bei ausgestrecktem Auslegerteil (36) auf einen vorbestimmten zweiten Druck aufgeblasen wird, wobei der vorbestimmte erste Druck etwa 0,21 bar und der vorbestimmte zweite Druck etwa 0,07 bar beträgt.

3. Notrutschen— und Rettungsfloßeinrichtung nach Anspruch 2, bei welcher das Seitenrohr (19, 20) ein Gewebe aufweist, das bei dem vorbestimmten ersten Druck dehnbar ist, um das Volumen der Einrichtung während des Ausfaltens des Rutschenteils (12) zu erhöhen und dadurch die Druckverminderung in der Einrichtung beim Ausfalten des Auslegerteils (36) zu minimisieren.

4. Notrutschen— und Rettungsfloßeinrichtung nach Anspruch 1, bei welcher der Rutschenteil (12) an einem Rand, der von dem zuerst erwähnten Seitenrohr abgewandt ist, ein zweites Seitenrohr (19, 20) aufweist und ein zweiter Auslegerteil (37) neben dem zweiten Seitenrohr angeordnet ist, der zweite Auslegerteil ein zweites Stützrohr (38, 39) aufweist, das an dem zweiten Seitenrohr befestigt ist und mit diesem kommuniziert, und ein aus flexiblem Flächenmaterial bestehendes zweites Passagier-Tragteil (44) sich zwischen dem zweiten Seitenrohr und dem zweiten Stützrohr erstreckt, so daß bei Benutzung der Einrichtung als Rettungsfloß der zweite Auslegerteil (37) Raum für zusätzliche Passagiere liefert.

5. Notrutschen— und Rettungsfloßeinrichtung nach Anspruch 4, bei welcher eine zweite Reffvorrichtung (45, 46) vorgesehen ist, um das zweite Stützrohr (38, 39) in teilweise aufgeblasenem Zustand an dem Rutschenteil (12) zurückzuhalten, sowie eine zweite Auslösevorrichtung zum Freigeben der zweiten Reffvorrichtung, unabhängig von dem Freigeben des ersten Auslegerteils (36).

**Revendications**

1. Un ensemble de toboggan d'évacuation et de radeau de sauvetage destiné à être gonflé et à s'étendre à partir d'une position surélevée vers une surface inférieure comprenant une partie de toboggan (12) ayant au moins un boudin latéral gonflable s'étendant longitudinalement (15, 16, 19, 20) sur l'un des côtés de ladite partie de toboggan, une partie porte-nage (36) adjacente audit boudin latéral, ladite partie porte-nage ayant au moins un boudin de support (38, 39) s'étendant dans le sens longitudinal et étant relié audit tube latéral (19, 20) par des boudins de support transversaux espacés l'un de l'autre (42, 43), et un élément de support des passagers en un matériau en feuille flexible (44) s'étendant entre ledit boudin latéral (19, 20), lesdits boudins de support transversaux (42, 43) et ledit boudin de support (38, 39) de telle sorte qu'au cours de l'utilisation dudit ensemble comme radeau, ladite partie porte-nage (36) ménagera un espace sur ledit élément de support (44) pour des passagers supplémentaires, un moyen de rissage (45, 46) étant attaché audit ensemble pour retenir ladite partie porte-nage (36) contre ladite partie de toboggan (12) et comportant des moyens de dégagement (49) pour dégager lesdits moyens de rissage (45, 46), caractérisé en ce que lesdits moyens de rissage (45, 46) présentent un rabat plat continu s'étendant en condition repliée ou de rissage autour dudit boudin de support (38, 39) et poussant la longueur dudit boudin de support contre le boudin latéral (19, 20) de telle sorte que lors du gonflage dudit ensemble avec ladite partie porte-nage (36) dans la condition de rissage, ledit boudin support, sur toute sa longueur, sera seulement partiellement gonflé et renforcera ledit boudin latéral (19, 20) de ladite partie de toboggan.

2. Un ensemble de toboggan d'évacuation et de radeau de sauvetage selon la revendication 1, caractérisé en ce que ledit ensemble est gonflé à une première pression déterminée lorsque ladite partie porte-nage (36) est dans la condition de rissage, puis ledit ensemble est gonflée à une seconde pression prédéterminée avec la partie porte-nage (36) à l'état déployé après dégagement desdits moyens de rissage (45, 46) par l'intermédiaire dudit moyen de dégagement (49), ladite première pression prédéterminée étant d'environ 0,21 bar et ladite seconde pression prédéterminée étant d'environ 0,07 bar.

3. Un ensemble de toboggan d'évacuation et radeau de sauvetage selon la revendication 2, caractérisé en ce que ledit boudin latéral (19, 20) est un tissu pouvant être étiré à ladite première pression prédéterminée pour augmenter le volume dudit ensemble au cours de l'extension de ladite partie de toboggan (12) de manière à diminuer la réduction de pression dans ledit ensemble au cours de l'extension de ladite partie porte-nage (36).

4. Un ensemble de toboggan d'évacuation et de radeau de sauvetage selon la revendication 1, caractérisé en ce que ladite partie de toboggan (12) présente un second boudin latéral (19, 20) du côté opposé audit premier boudin latéral mentionné et une seconde partie porte-nage (37) disposée en étant adjacente audit second boudin latéral, ladite seconde partie porte-nage présentant un second boudin de support (38, 39) relié à et en communication avec ledit second boudin latéral et un second élément de support de passager réalisé en un matériau en feuille flexible (44) s'étendant entre ledit second boudin latéral et ledit second boudin de support de telle sorte qu'au cours de l'utilisation dudit ensemble comme radeau de sauvetage, ladite seconde partie port-nage (37) assurera un espace pour des passagers supplémentaires.

5. Un ensemble de toboggan d'évacuation et de radeau de sauvetage selon la revendication 4, caractérisé en ce qu'un second moyen de rissage (45, 46) est ménagé pour retenir ledit second boudin de support (38, 39) dans une condition partiellement gonflée contre ladite partie de toboggan (12) et un second moyen de dégagement pour dégager lesdits seconds moyens de rissage indépendamment du dégagement de ladite première partie porte-nage (36).

Fig.1

Fig.2

Fig.3

Fig.4

Fig.5

Fig.6

0 034 358

0 034 358

Fig. 7

Fig. 8

Fig. 9

3